# EUROPEAN PATENT SPECIFICATION

(11) **EP 0 513 821 B1**
(45) Date of publication and mention of the grant of the patent: **11.08.1999**
(21) Application number: 92108247.5
(22) Date of filing: 15.05.1992
(51) Int. Cl.: C23C 18/12, C23C 18/08

(54) **Method of producing metallic thin film**
Verfahren zur Herstellung dünner Metallfilme
Procédé de préparation d'un film métallique mince

(30) Priority: 18.05.1991 JP 14246091
(43) Date of publication of application: 19.11.1992
(73) Proprietor: HORIBA, LTD., Minami-ku Kyoto (JP)
(72) Inventor: Tonmita, Katsuhiko, Ohtsu-city, Shiga-pref. (JP)
(74) Representative: Müller, Frithjof E., Dipl.-Ing.

(56) References cited:
- EP-A- 0 316 452
- PATENT ABSTRACTS OF JAPAN vol. 12, no. 248 (C-511)(3095) 13 July 1988 & JP-A-63 035 780 (FURUKAWA ELECTRIC)
- JOURNAL OF NON-CRYSTALLINE SOLIDS vol. 100 , 1988 , AMSTERDAM NL pages 1 - 15 R.C. MEHROTRA 'SYNTHESIS AND REACTIONS OF METAL ALKOXIDES'
- THIN SOLID FILMS vol. 165 , November 1988 , LAUSANNE CH pages 317 - 322 K.R. SPECK ET AL 'VANADIUM DIOXIDE FILMS GROWN FROM VANADIUM TETRAISOPROPOXIDE BY THE SOL-GEL PROCESS'
- Römpp, Lexikon Chemie, 10. Auflage, 1997, page 1071 "Edelmetalle".
- Römpp, Lexikon Chemie, 8. Auflage, 1997, page 1040 "Edelmetalle".
- Lehrbüch der Anorganischen Chemie, 91-110 Auflage, page 1188, Chapter 4 "Chemische Eigeschaften"

## Description

### Background of the Invention

### Field of the Invention

The present invention relates to a method of producing a metallic thin film, in which a thin film is formed on a substrate by the use of noble metal alkoxides alone or metal alkoxides containing noble metal alkoxides as main components or as additives in minor amounts. The metallic thin film is used, for example, in a pH-response sensor, a hydrogen sensor, gas sensors and other kinds of various applications.

### Description of the Prior Art

As methods of forming a metallic thin film on a surface of a substrate there have been well known, for example, an evaporation method, in which a target set within a vacuum bell jar is heated to be vaporized, followed by depositing the resulting vapor on a substrate while forming a thin film; a sputtering method, in which a target within a vacuum bell jar is stuck to a substrate by a glow discharge to form a thin film; or a method in which a substrate is immersed in a metallic melt to form a thin film, followed by drying and then baking, whereby a metallic film is formed.

Said vapor deposition method or said sputtering method is advantageous in that the thin film can be prepared with uniform thickness or in that impurities can be removed. When taking oxides as an object, the sputtering method is suitable for high-melting-point substances. However, problems have occurred in that, since the thin film is formed within a vacuum bell jar in said methods, a complicated and expensive apparatus is required. If oxides are used as the target, it is necessary to regulate said oxides in purity; and if the target is porous, a pretreatment is required. Moreover, problems have occurred also in that in the case where a thin film of multi-component metals or metal oxides is formed, it is necessary to prepare various kinds of target. For vapor depositing or sputtering said various kinds of target simultaneously or in turn, a still more expensive apparatus is required.

EP-A-0 316 452 discloses a method for producing a base metal thin film which comprises the formation of a layer of an organic or inorganic base metal compound on a substrate and the thermal decomposition of said compound, resulting in a metallic oxide. Further, said metallic oxide is heated and reduced.

JP-A-63-35780 discloses a method for plating of noble metals by applying a viscous solution containing a noble metal abietate. The applied solution is heated, resulting in the deposition of the noble metal.

### Summary of the Invention

It is an object of the present invention to provide a method of producing a metallic thin film which is simple and inexpensive and which allows the formation of a thin film of monocomponent or multicomponent noble metals or noble metal oxides.

According to a first aspect, the present invention provides a method of producing a metallic thin film on a substrate, which is characterized in that a solution of at least one noble metal alkoxide is prepared in a moisture-free atmosphere, a thin film of said solution is formed on a substrate, then dried and baked, either in a reductive atmosphere to form a thin film of noble metals or in an oxidative atmosphere to form a thin film of noble metal oxides.

According to a second aspect, the method of the invention is characterized in that metal alkoxides containing at least one noble metal alkoxide as main component or as additives in minor amounts are used in place of said solution ofnoble metal alkoxides according to said first aspect of the invention.

For example, Au, Pt, Pd, Rh, Ir, Ru, Os orAg can be optionally used as said noble metals and a coating solution comprising these noble metal alkoxides may contain merely a single component or a plurality of components. At least one thin layer of metals or metal oxides consisting of noble metals alone or mainly of noble metals or containing noble metals in minor amounts can be piled up in optional combination.

In addition, in the case where the noble metal alkoxides are used as said main components, or as additives in minor amounts, other metal alkoxides as the main components or the additives can be optionally selected depending upon the use of the thin film.

Said substrate can be optionally selected depending upon the use of the thin film. It can be made of, for example, Si or metals such as Al, Au, Ti and Ta.

If it is desired to pile up a plurality of layers of thin film on said substrate, a thin film of a solution of at least one metal alkoxide is formed again on said thin film of metal or metal oxides formed on the substrate, before baking it in said reductive or oxidative atmosphere.

The method of forming the thin film from said solution of at least one metal alkoxide can be optionally selected. For example, an application by spraying and other optional means, a drawing-up method, in which the substrate is immersed in the solution of noble metal alkoxides to be drawn up or a spin coating method, in which the solution of noble metal alkoxides is fallen on a rotating substrate drop by drop to form the thin film by a centrifugal force.

According to a third aspect, the method of the invention is characterized in that before baking, the film formation is repeated at least one times to pile-up a plurality of metallic thin film layers on said substrate.

According to said first aspect of the invention, the thin film of the solution of noble metal alkoxides is formed, for example, by applying a solution obtained by adding solvents to noble metal alkoxides (sol) to a surface of the substrate followed by drying. In the formation of the noble metallic thin film, the dried thin film is baked at a desired temperature in a reductive atmosphere. In the formation of the thin layer of noble metal oxides, the above described dried thin film is baked in an oxidative atmosphere.

According to said second aspect of the invention, said thin film of a solution obtained by adding base metal alkoxides, which are selected depending upon the intended use of the film, to the noble metal alkoxides as the main components or the thin film of a solution containing said base metal alkoxides as the main components and the noble metal alkoxides as the additives in minor amounts is formed on the substrate. Then, the thin film formed on the substrate is baked in the same manner as in the first method of the invention to form the metallic thin film or the metal oxide thin film containing the noble metals as main components or as additives in minor amounts.

According to said third aspect of the invention, said thin film of metal alkoxides is formed again on the metallic thin film or the metal oxide thin film formed on the substrate before baking it in the reductive or oxidative atmosphere, whereby piled-up thin films comprising a plurality of layers are formed.

### Brief Description of the Drawings

Fig. 1 is a flow chart schematically showing the present invention;
Figs. 2 is a schematic drawing showing a spin coating apparatus used in a first preferred embodiment;
Fig. 3 is an enlarged front view showing a substrate in said first preferred embodiment;
Fig. 4 is a perspective view showing thin film-forming means used in a second preferred embodiment; and
Fig. 5 is an enlarged front view showing a substrate in said second preferred embodiment.

### Detailed Description of the Preferred Embodiments

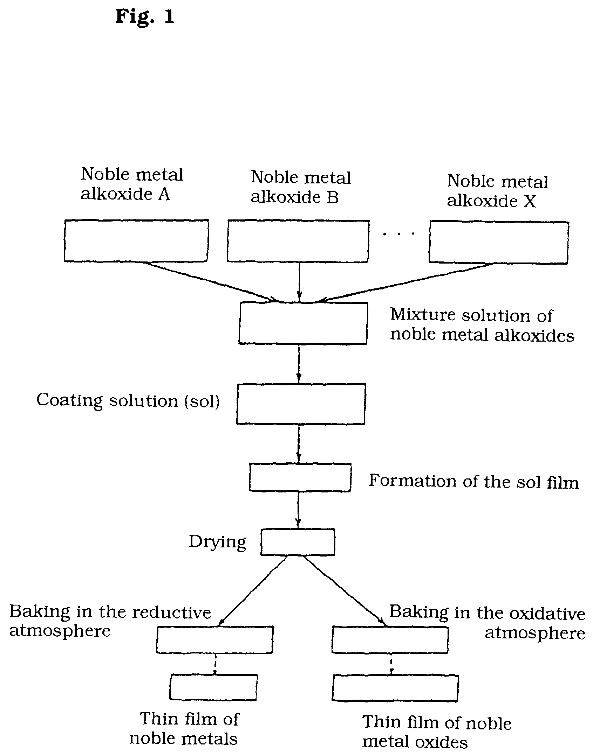

An outline of a preferred embodiment of a method of producing a metallic thin film according to the present invention will be described below with reference to said flow chart shown in Fig. 1.

At first, a noble metal alkoxide mixture comprising noble metal alkoxides A, B ··· X selected depending upon the intended use at a desired ratio is dissolved, for example, in organic solvents, to form mixture solution of noble metal alkoxides (sol) and the resulting mixture solution of noble metal alkoxides is sufficiently stirred to prepare a coating solution with the components homogenized. Then, a thin film of said coating solution is formed on the surface of a substrate, made, for example, of Si. The means of forming the thin film from the coating solutions is optionally selected.

Subsequently, the thin film of the coating solution is dried, for example, by heating. Since the thin film is gelatinized by this heating, the dried thin film is baked in a reductive atmosphere to form a thin film consisting of a plurality of noble metals, or is baked in an oxidative atmosphere to form a thin film consisting of a plurality of noble metal oxides (the first aspect of the invention).

It is also possible to form a thin film consisting only of one kind of noble metal or noble metal oxide by the use of any one kind of noble metal alkoxide selected from a plurality of noble metal alkoxides A, B ··· X (the first aspect of the invention).

In addition, although a plurality of noble metal alcoxides A, B ··· X are mixed and dissolved to form the coating solution in the flow chart shown in Fig. 1, it is for example also possible that the respective solutions of the noble metal alkoxides A, B ··· X may be prepared and then mixed.

Further, although a plurality of merely noble metal alkoxides are used in the flow chart shown in Fig. 1, it is also possible to form a thin film consisting of a plurality of kinds of metals or metal oxides containing noble metals from a coating solution prepared by mixing at least one of these noble metal alkoxides A, B ··· X with base metal alkoxides suitably selected (the second aspect of the invention).

In addition, it is also possible to form a multi-layer thin film by repeating the formation of the thin film consisting of metals or metal oxides, as described above (the third aspect of the invention).

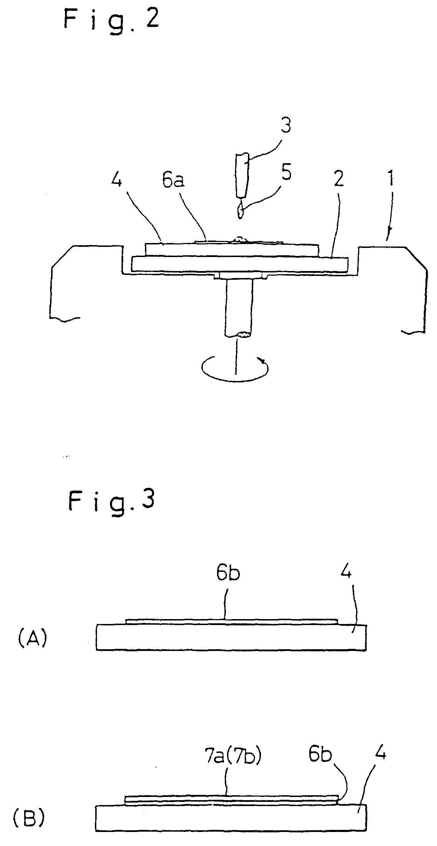

Next, a first preferred embodiment using platinum as the noble metal is described with reference to Figs. 2, 3 (A) and 3 (B). This first preferred embodiment corresponds to the first aspect of the invention and the third aspect of the invention).

Referring to Fig. 2, reference numeral 1 designates a spin coating apparatus comprising a turning table 2 revolved by means of a motor (not shown) and a nozzle 3 arranged above a center of said turning table 2 for falling the coating solution drop by drop.

Platinum alkoxides [Pt - (O - R)] (R: - CH₃, - C₂H₅, - C₃H₇) are dissolved in dehydrated ethyl alcohol in a quantity of 2.5 % by weight and a quantity equivalent in mol to said alkoxides of acetic acid is added to the resulting solution as a catalyst. This composition is sufficiently stirred and mixed in a stream of nitrogen gas, so as to be not brought into contact with moisture, whereby a first coating solution is prepared.

Subsequently, a substrate 4 made of Si is set at said central portion of the turning table 2 to revolve said substrate 4 at about 4,000 rpm together with the turning table 2. Then said first coating solution 5 is fallen on the substrate 4 from said nozzle 3 drop by drop at a rate of 100 to 200 µl/about 30 seconds followed by spin coating the first coating solution on a surface of the substrate 4 to form a thin film 6a. Said thin film 6a formed on the substrate 4 in the above described manner is dried for 30 minutes at 100 to 150 °C and then baked for 30 minutes at 600 °C in a reductive atmosphere to form a Pt thin film 6b on said surface of the substrate 4, as shown in Fig. 3 (A).

In addition, a second coating solution containing platinum alkoxides in a concentration of 5 % by weight is prepared similarly to the first coating solution 5. The substrate 4 shown in Fig. 3 (A) is set again on the turning table 2 with said Pt thin film 6b on an upper side (not shown) to spin coat said second coating solution on the Pt thin film 6b under the same conditions as in the spin coating of the first coating solution 5, whereby a thin film 7a consisting of the second coating solution on the Pt thin film 6b is formed, as shown in Fig. 3 (B), followed by drying said thin film 7a under the same conditions as for the thin film 6a. Subsequently, the thin film 7a is baked for 30 minutes at 350 °C in an oxidative atmosphere to form a PtO thin film 7b, whereby the thin film consisting of noble metals and the thin film consisting of noble metal oxides are formed in superposed layers on the substrate 4.

The thin film 6a and the thin film 7a of the first coating solution and the second coating solution containing platinum alkoxides, respectively, are formed in turn on the substrate 4 and then the thin films 6a, 7a are baked in turn in a reductive or oxidative atmosphere to form the thin film consisting of noble metals and the thin film consisting of noble metal oxides in the form of superposed layers, so that no complicated apparatus is required and thus the manufacturing expenses can be easily reduced.

The thicknesses of the thin film 6a consisting of the first coating solution and that of the thin film 7a consisting of the second coating solution are set, for example, by regulating the respective concentrations of the first coating solution and the second coating solution or the rotation frequency of the turning table 2.

The heating temperature in the reductive atmosphere is set within a range of 500 to 600 °C and that in the oxidative atmosphere is set within a range of 300 to 400 °C. For example, N₂ or H₂ can be used as the reductive atmosphere. The rotation frequency of the turning table 2 is set within a range of, for example, 3,000 to 5,000 rpm.

Although the thin film consisting of noble metals and the thin film consisting of noble metal oxides are formed on the substrate 4 in a plurality of layers in this first preferred embodiment, it is also possible to form the thin film consisting of noble metals or noble metal oxides in a single layer.

In the case where the thin film is formed in a plurality of layers, noble metal alkoxides forming the respective layers may be different from each other and various kinds of metal alkoxides containing noble metal alkoxides as main components or as additives in minor amounts may be used. In addition, a part of a plurality of layers of thin film can be formed by the use of base metal alkoxides or semiconductor alkoxides, so that it is also possible to form the multi-layer thin film in various kinds of combination, such as metal oxide/noble metal oxide/noble metal and noble metal/metal oxide/semiconductor, depending upon the use of the thin film.

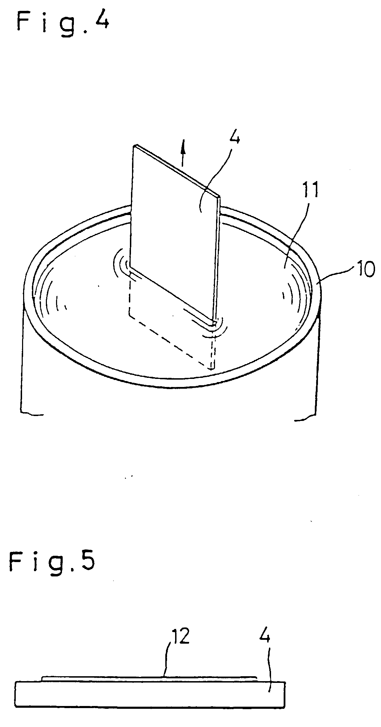

A second preferred embodiment using a noble metal, namely Ir, as an additive to the base metals is described with reference to Figs. 4 to 5. This second preferred embodiment corresponds to the second aspect of the invention.

According to the second preferred embodiment, a suitable quantity of isopropoxy iridium [Ir(OC₂H₅)₅] as the noble metal alcoxide is added to pentaethoxy tantalum [Ta(OC₂H₅)₅] as a tantalum alcoxide [Ta - (O - R)₅] to prepare a coating solution in the same manner as in the first preferred embodiment.

Referring to Fig. 4, reference numeral 10 designates a vessel containing said coating solution 11 therein. A substrate 4 is immersed in the coating solution 11 and then drawn up to form a thin film on a surface of said substrate 4. After drying, said thin film is baked in an oxidative atmosphere to form a metal oxide thin film 12 consisting of Ta₂O₅ with Ir added on the substrate 4, as shown in Fig. 5. The electrical resistance value of said metal oxide thin film 12 can be regulated to be within a range of high-insulating to low-insulating, for example within about 10⁷ to 10⁴ Ω, by adjusting the molar ratio of isopropoxy iridium added.

The metal oxide thin film 12 is used, for example, as a pH sensor, but oxides of Ir and other noble metals added exhibit a response to pH even influenced by the oxidation and the reduction, so that noble metals, as Ir, when added can improve the response of the metal oxide thin film 12 in the case where the metal oxide thin film 12 is used as a pH sensor.

For example. when the metal oxide thin film 12 is formed on a substrate of ISFET, an ion concentration-measuring electrode superior in response can be constructed.

In addition, although noble metal alkoxides are used as additives in the second preferred embodiment, noble metal alkoxides may be used as main components and base metal alkoxides may be added to noble metal alkoxides. Further, although the thin film is formed in a single layer on the substrate 4 in the second preferred embodiment, the thin film may be formed in a plurality of layers, as shown in the first preferred embodiment.

As is obvious from the first and second preferred embodiments, noble metal alkoxides can be optionally selected depending upon the use. If a thin film of a coating solution containing for example palladium alkoxides (Pd - O - R, R: - C₃H₇, - C₅H₉) in a concentration of 10 % by weight is formed, then dried and baked, whereby a porous metallic Pd thin film is formed on a substrate of a MOSFET, said porous metallic Pd thin film can be used as a hydrogen sensor.

In addition, if a thin film of a coating solution containing Pt alkoxide is formed on a substrate of a MOSFET and baked in a reductive or oxidative atmosphere, whereby a Pt or PtO thin film is formed, said Pt or PtO thin film can be used as a gas sensor due to the catalytic action thereof.

In the case where a coating solution containing a plurality of alkoxides for use in pH glass response, for example alkoxides of Si, Lt, La, Ti or Ba, is prepared to form a pH-responsive film, and a thin film of noble metal alkoxides is used as an oxidative layer, the adhesion of said oxidative layer to said glass-responsive film can be improved and thus a separation can be suitably prevented.

According to the method of the invention, it is possible to produce a single-component thin film in high efficiency and inexpensively. Also in the case where a multi-component thin film is formed, it is sufficient that a coating solution containing the respective noble metal alkoxides or noble metal alkoxides and base metal alkoxides in mixture is prepared to form the thin film thereof, so that it is unnecessary to use a complicated and large-scaled apparatus for forming a multi-component thin film, and thus it is possible to easily and inexpensively form a multi-component thin film. In addition, since the coating solution contains noble metal alkoxides or noble metal alkoxides and base metal alkoxides in mixture, it is also possible to easily control the crystalline and amorphous structure of the respective ingredients or the compactness of the porous thin film, and thus it is possible to produce a thin film having the structure corresponding to the intended use.

In addition, in the method according to claim 3, the metallic thin film or the metal oxide thin film which is formed from the solution of optional metal alkoxides in the same manner as the above described metallic or metal oxide thin film, is piled up in layers, so that it is possible to produce a thin film having a structure corresponding to various kinds of use by selecting the desired components of the thin film and setting the number of layers constituting the thin film.

## Claims

1. A method of producing a metallic thin film on a substrate, **characterized in that** a solution of at least one noble metal alkoxide is prepared in a moisture-free atmosphere, a thin film of said solution is formed on a substrate, then dried and baked either in a reductive atmosphere to form a thin film of noble metals or in an oxidative atmosphere to form a thin film of noble metal oxides.

2. A method of producing a metallic thin film on a substrate, **characterized in that** a solution of metal alkoxides containing at least one noble alkoxide as the main component or as additive in minor amounts is prepared in a moisture-free atmosphere, a thin film of said solution is formed on a substrate, then dried and baked either in a reductive atmosphere to form a thin film of metals or in an oxidative atmosphere to form a thin film ofmetal oxides.

3. The method according to claim 1 or 2, **characterized in that**, before baking, the film formation is repeated at least one times to pile-up a plurality of thin film layers on said substrate.

## Patentansprüche

1. Verfahren zur Herstellung eines metallischen Dünnfilms auf einem Träger, **dadurch gekennzeichnet,** dass eine Lösung mindestens eines Edelmetallalkoxids in einer Atmosphäre frei von Feuchtigkeit hergestellt wird, ein Dünnfilm dieser Lösung auf einem Träger erzeugt wird und anschließend getrocknet und entweder in einer reduzierenden Atmosphäre zur Herstellung eines Edelmetall-Dünnfilms oder in einer oxidierenden Atmosphäre zur Herstellung eines Edelmetalloxid-Dünnfilms thermisch behandelt wird.

2. Verfahren zur Herstellung eines metallischen Dünnfilms auf einem Träger, **dadurch gekennzeichnet**, dass eine Lösung von Metallalkoxiden, die mindestens ein Edelmetallalkoxid als Hauptbestandteil oder als Additiv in geringer Menge enthält, in einer Atmosphäre frei von Feuchtigkeit hergestellt wird, ein Dünnfilm dieser Lösung auf einem Träger erzeugt wird und anschließend getrocknet und entweder in einer reduzierenden Atmosphäre zur Herstellung eines metallischen Dünnfilms oder in einer oxidierenden Atmosphäre zur Herstellung eines Metalloxid-Dünnfilms thermisch behandelt wird.

3. Verfahren nach Anspruch 1 oder 2, **dadurch gekennzeichnet**, dass vor der thermischen Behandlung die Erzeugung des Films mindestens einmal wiederholt wird, um so eine Mehrzahl von Dünnfilmschichten auf dem Träger aufzubauen.

## Revendications

1. Procédé de préparation d'un film métallique mince sur un substrat, caractérisé en ce que l'on prépare une solution d'au moins un alcoxyde de métal noble en atmosphère exempte d'humidité, que l'on forme un film mince de ladite solution sur un substrat, puis que l'on sèche et cuit soit en atmosphère réductrice pour former un film mince de métaux nobles soit en atmosphère oxydante pour former un film mince d'oxydes de métaux nobles.

2. Procédé de préparation d'un film métallique mince sur un substrat, caractérisé en ce que l'on prépare une solution d'alcoxydes de métaux contenant au moins un alcoxyde noble en tant que constituant principal ou en tant qu'additif en quantités mineures en atmosphère exempte d'humidité, que l'on forme un film mince de ladite solution sur un substrat, puis que l'on sèche et cuit soit en atmosphère réductrice pour former un film mince de métaux soit en atmosphère oxydante pour former un film mince d'oxydes de métaux.

3. Procédé selon la revendication 1 ou 2, caractérisé en ce qu'avant la cuisson, la formation du film est répétée au moins une fois pour entasser plusieurs couches en film mince sur ledit substrat.
